Europäisches Patentamt

European Patent Office

Office européen des brevets

(11) Publication number: **0 178 186**
**B1**

(12) **EUROPEAN PATENT SPECIFICATION**

(45) Date of publication of patent specification: **12.09.90**

(51) Int. Cl.⁵: **C 23 C 14/50** // C23C16/44

(21) Application number: **85307326.0**

(22) Date of filing: **14.10.85**

(54) Planetary substrate carrier.

(30) Priority: **12.10.84 US 659988**

(43) Date of publication of application:
**16.04.86 Bulletin 86/16**

(45) Publication of the grant of the patent:
**12.09.90 Bulletin 90/37**

(84) Designated Contracting States:
**DE FR GB**

(56) References cited:
**EP-A-0 090 461
DE-A-2 053 802
DE-A-2 813 180
US-A-4 284 033**

**PATENT ABSTRACTS OF JAPAN, vol. 6, no. 143
(C-117)1021r, 3rd August 1982; & JP-A-57 67 163
(TONAN KINZOKU KOGYO K.K.) 23-04-1982**

**IBM TECHNICAL DISCLOSURE BULLETIN, vol.
14, no. 12, May 1972, pages 3693-3694, New
York, US; T.A. GUNTHER et al.: "Evaporation
wafer carrier"**

(73) Proprietor: **Hewlett-Packard Company
Mail Stop 20 B-O 3000 Hanover Street
Palo Alto California 94304 (US)**

(72) Inventor: **Bloomquist, Darrel R.
8843 Mornin Mist
Boise Idaho 83709 (US)**
Inventor: **Drennan, George A.
347 North Eagle Road
Eagle Idaho 83616 (US)**
Inventor: **Opfer, James E.
3115 Bandera Drive
Palo Alto California 94304 (US)**

(74) Representative: **Colgan, Stephen James et al
CARPMAELS & RANSFORD 43 Bloomsbury
Square
London WC1A 2RA (GB)**

Courier Press, Leamington Spa, England.

## Description

This invention relates to the production of deposited-film parts at elevated temperatures and high vacuum. More particularly, the invention relates to support and movement of parts in production quantities in vacuum deposition environments. The principal concern in high vacuum, elevated temperature, thick or thin film deposition systems is to minimize the sources of particles within the deposition chambers which contaminate the deposition process itself. Typically, a major source of particles results from actuation or frictional engagement of metal parts.

Some deposited-film parts, such as disc memory media, require selectively uniform film deposition on both sides of a substrate. Various mechanical devices requiring complex manipulators for handling such substrates are expensive and are difficult to maintain. Moreover, such devices are frequently not adaptive to different size substrates that a manufacturer may wish to process.

The present invention provides a substrate carrier for supporting substantially planar substrates each having a central hole during film deposition processing, said carrier comprising a chassis; and a plurality of means provided on the chassis for supporting the substrates in vertical attitude so that the substrates are suspended therefom at the periphery of the central hole of the or each substrate.

The substrate carrier as set forth in the last preceding paragraph, is characterised in that the plurality of means comprises a plurality of sheaves mounted on the chassis, the sheaves being aligned in one or more vertical planes; and the sheaves each have a groove formed in the circumferential edge for suspending a substrate by the periphery of the central hole of the substrate.

A substrate carrier as defined in the penultimate paragraph is described, for example in Patent Abstracts of Japan, Vol. 6, No. 143 (C-117) (1021), 3rd August 1982 and JP—A—57—67163).

The chassis may be made of an aluminium alloy or stainless steel; each sheave may preferably be made of stainless steel.

Preferably, each sheave is mounted on a respective mount supported by arms in an aperture in the chassis, the mount and arms being integrally formed with the chassis.

The substrate carrier of the preferred illustrated embodiment according to the present invention comprises a plurality of sheaves rigidly attached to a vertically oriented flat plate having a center hub around which it can rotate. Each sheave is also vertically oriented and grooved around its circumferential edge. The grooves are formed to accommodate the thickness of the substrates to be processed. The sheaves are smaller in diameter than the diameter of holes at the center of each substrate.

Each substrate is suspended on a sheave by the center hole. Rotation of the carrier around its center causes each substrate to roll on its sheave. Continuous rolling of the substrates during deposition assures uniform deposition of film.

There now follows a detailed description which is to be read with reference to the accompanying drawings of a substrate carrier according to the present invention; it is to be clearly understood that this substrate-carrier has been selected for description to illustrate the invention by way of example and not by way of limitation.

In the accompanying drawings:—

Figure 1 is a perspective view of a substrate carrier constructed according to the present invention;

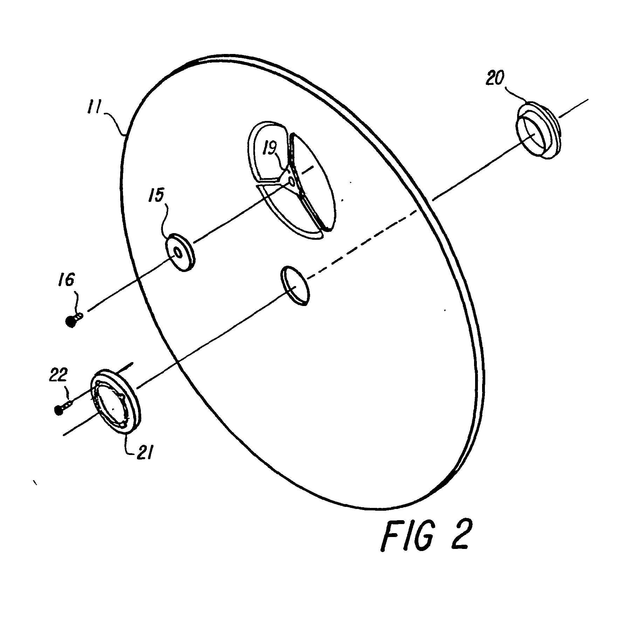

Figure 2 is an exploded view of the substrate carrier of Figure 1; and

Figure 3 is a top view of the sheave support structure for the substrate carrier of Figures 1 and 2.

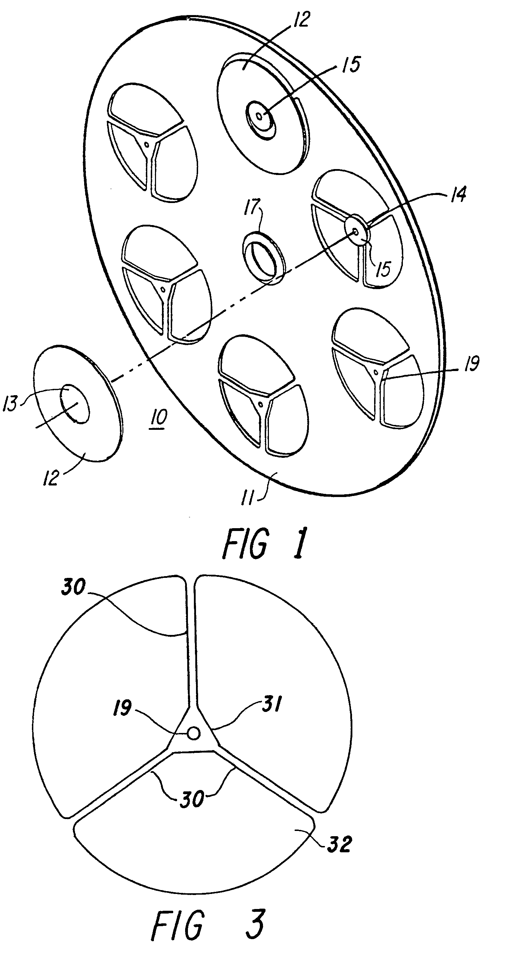

Referring to Figure 1, the vertically-oriented substrate carrier 10 illustrated therein comprises a chassis 11 incorporating a plurality of sheave support structures 19 on which sheaves 15 are mounted in parallel with the plane of the chassis 11. The substrate carrier 10 is coupled to a motor drive (not shown) for rotating the carrier 10 in the plane of the chassis 11 at selected speeds during processing of substrates 1.

The sheaves 15 are grooved around their circumferences very much like a pulley wheel and are fixedly mounted to the support structures 19 by respective screws 16. The substrates 12 are suspended by the periphery of central holes 13 engaging in the grooves 14 of the sheaves 15, and since they merely rest in the grooves 14, loading and unloading of the substrates 12 from the carrier 10 is greatly simplified.

Rotation of the substrates 12 is desirable to assure circumferential uniformity of the magnetic properties as well as the thickness of the deposited film. As the carrier 10 rotates at a preselected speed, the substrates 12 simply roll along the grooves 14 of the sheaves 15. For each revolution of the carrier 10, each substrate completes a fraction of a revolution on its sheave given by the ratio

$$\frac{D_1}{D_2},$$

where $D_1$ is the diameter of the groove 14 in the sheave and $D_2$ is the diameter of the hole 13 in the substrate 12.

Referring now to Figure 3, the sheave support structure 19 comprises a mount 31 suspended in a hole 32 by support arms 30. Thus, the other side of the substrate 12 can be exposed to a deposition environment. Since the substrates 12 continuously rotated on the sheaves 15 as the carrier 10 rotates, the sheave support arms 30 do not interfere with uniform deposition of films on the second side of the substrate 12. Hence, the carrier 10 provides for simultaneous deposition of films onto both sides of the substrates 12. It should be noted that the chassis 11 also provides a ground plane for electrical isolation of deposition environments, such as plasma, for the two-sided deposition process.

As mentioned before, film deposition systems are sensitive to the presence of random metal particles or shavings resulting from actuation of frictionally-engaging metal parts. Such particles and shavings contaminate the deposition environment. The carrier 10 provides substrate rotation while producing substantially no contaminating particles since each substrate simply rolls in its respective groove 14 as the sheave 15 is rotated.

The carrier 10 can accommodate thin, planar substrates of various sizes and shapes. All that is required is that the substrate has a circular hole concentric with its center of gravity which can be fitted onto a sheave. While round substrates with concentric holes are illustrated and preferred for the embodiment described, substrates of virtually any shape can be accommodated.

The parts of the substrate carrier 10 can be constructed of any material suitable for high-vacuum, high-temperature environments. Typically, the chassis 11 is constructed of aluminium alloy, while the sheaves 15 and hub parts 20, 21 and 22 are constructed of stainless steel. The sheave support structure 19 is an integral part of the chassis 11. If the temperature of the deposition process exceeds 180° centigrade, the chassis 11 may be made of stainless steel also.

The substrate carrier of the present invention particularly the sheave suspension feature, requires no lubrication. Thus, contamination from that source is eliminated.

## Claims

1. A substrate carrier (10) for supporting substantially planar substrates each having a central hole during film deposition processing, said carrier comprising:
a chassis (11); and
a plurality of means (19) provided on the chassis for supporting the substrates (12) in vertical attitude so that the substrates are suspended from at the periphery of the central hole of the or each substrate;
characterised in that:
the plurality of means comprises a plurality of sheaves (15) mounted on the chassis, the sheaves being aligned in one or more vertical planes; and
the sheaves each have a groove (14) formed in the circumferential edge for suspending a substrate by the periphery of the central hole of the substrate.

2. A substrate carrier according to claim 1, wherein the chassis is made of an aluminium alloy or stainless steel.

3. A substrate carrier according to claim 1 or 2, wherein each sheave is made of stainless steel.

4. A substrate carrier according to any of claims 1 to 3, wherein each sheave is mounted on a respective mount support by arms in an aperture in the chassis, the mount and arms being integrally, formed with the chassis.

## Patentansprüche

1. Substratträger (10) zum Unterstützen von im wesentlichen ebenen Substraten, die jeweils ein zentrales Loch für eine Filmablagerungsbehandlung aufweisen, mit
einem Chassis (11) und
einer Vielzahl von Vorrichtungen (19) am Chassis zum Unterstützen der Substrate (12) in vertikaler Ausrichtung, so daß die Substrate am Umfang jeweils des zentralen Loches aufgehängt sind,
dadurch gekennzeichnet, daß
die Vorrichtungen Scheiben (15) aufweisen, welche am Chassis montiert sind und in einer oder mehreren vertikalen Ebenen ausgerichtet sind, und
die Scheiben jeweils eine Nut (14) im Umfangsrand zum Aufhängen eines Substrats mittels des Umfangs des zentralen Lochs des Substrates haben.

2. Substratträger nach Anspruch 1, bei dem das Chassis aus einer Aluminiumlegierung oder aus rostfreiem Stahl hergestellt ist.

3. Substratträger nach Anspruch 1 oder 2, bei dem jede Scheibe aus rostfreiem Stahl besteht.

4. Substratträger nach einem der Ansprüche 1 bis 3, bei dem jede Scheibe an einem zugehörigen Montagepunkt, welcher durch Arme in einer Öffnung des Chassis unterstützt ist, angebracht ist, wobei der Montagepunkt und die Arme einstückig mit dem Chassis ausgebildet sind.

## Revendications

1. Porte-substrate (10) destiné à supporter, pendant l'opération de dépôt d'une couche, des substrats sensiblement plans, comportant chacun un trou central, ledit porte-substrat comprenant:
—un châssis (11); et
—une pluralité de moyens (19) disposés sur le châssis pour supporter les substrats (12) en position verticale de façon que les substrats soient suspendus à ceux-ci à la périphérie du trou central du substrat ou de chacun d'eux;
caractérisé en ce que:
la pluralité de moyens comprennent plusieurs réas (15) montés sur le châssis, les réas étant alignés dans un ou plusieurs plans verticaux; et
les réas comportent chacun une rainure (14) formée dans le bord circonférentiel pour suspendre un substrat par la périphérie du trou central du substrat.

2. Porte-substrat selon la revendication 1, dans lequel le châssis est en alliage d'aluminium ou en acier inoxydable.

3. Porte-substrat selon la revendication 1 ou 2, dans lequel chaque réa est acier inoxydable.

4. Porte-substrat selon l'une quelconque des revendications 1 à 3, dans lequel chaque réa est monté sur un support respectif porté par des bras dans une ouverture du châssis, le support et les bras étant formés d'un seul tenant avec le châssis.

FIG 1

FIG 3

FIG 2